# EUROPEAN PATENT SPECIFICATION

(11) **EP 3 401 970 B1**
(45) Date of publication and mention of the grant of the patent: **29.09.2021**
(21) Application number: 16840275.8
(22) Date of filing: 02.08.2016
(51) Int. Cl.: H01L 51/50, H01L 51/56, H01L 27/32

(54) **PREPARATION METHOD FOR A QUANTUM DOT LIGHT-EMITTING DIODE SUBSTRATE**
HERSTELLUNGSVERFAHREN FÜR EINES QUANTENPUNKT-LEUCHTDIODENSUBSTRAT
PROCÉDÉ DE FABRICATION D'UN SUBSTRAT DE DIODES ÉLECTROLUMINESCENTES À POINTS QUANTIQUES

(30) Priority: 08.01.2016 CN 201610012450
(43) Date of publication of application: 14.11.2018
(73) Proprietor: BOE Technology Group Co., Ltd., Beijing 100015 (CN)
(72) Inventor: LI, Yanzhao, Beijing 100176 (CN); LEE, Chung Chun, Beijing 100176 (CN); CHEN, Zhuo, Beijing 100176 (CN); ZHANG, Yuanming, Beijing 100176 (CN)
(74) Representative: Klunker IP Patentanwälte PartG mbB
(86) International application number: PCT/CN2016/092849
(87) International publication number: WO 2017/117994

(56) References cited:
- WO-A1-2005/055330
- CN-A- 1 960 024
- CN-A- 101 207 075
- CN-A- 103 226 260
- CN-A- 105 449 111
- US-A1- 2009 085 473
- US-A1- 2012 113 672
- US-A1- 2013 009 131

## Description

### TECHNICAL FIELD

The present invention relates to a method of preparing a quantum dot light-emitting diode substrate having a bonding layer.

### BACKGROUND

Active matrix organic light-emitting diode (AMOLED) has been recognized as a promising alternative to liquid crystal display (LCD) as the next-generation display. However, with consumers' raised consumption level, high-resolution products have become the focus for the development of display products, yet high-resolution AMOLED products can hardly compete with LCD. This is because the organic layer structure of an organic light-emitting display is typically prepared by a mask evaporation method which has disadvantages such as alignment difficulty, a low qualified product rate, incapacity to achieve luminescence of a smaller pixel area, and incapacity to accurately control the evaporation area, and thus cannot meet the increasing requirements for high-resolution display. Moreover, the resolution of the organic light-emitting layer prepared by a printing method in place of a mask evaporation method is extremely limited. Therefore, high-resolution AMOLED products are presented with problems such as high technical difficulty, a low qualified product rate, and high prices.

Quantum dots (QDs), also known as nanocrystals, are nanoparticles comprised of elements of Groups IIB and VIA or Groups IIIA and VA. Quantum dots generally have a particle size between 1 and 20 nm, and can emit fluorescence upon being exited as the continuous energy band structure is changed into a discrete energy level structure due to quantum confinement of electrons and holes.

With the further development of quantum dot technology and the further research of electron-induced quantum dot light-emitting diodes, quantum efficiency has been improved to basically reach an industrialized level. It has become a trend to further adopt new techniques and processes to realize industrialization. In order to enhance the resolution of OLED, it is desirable to further reduce the line width of the Mask process when an OLED evaporation mask plate is used, and a printing nozzle with a greater precision is also desirable, which yet can hardly be satisfied in a mass production process. Therefore, there is a need for a method for large-scale preparation of quantum dot light-emitting diodes, which can achieve high resolution, improve the qualified product rate, and enhance quantum dot utilization.

US 2009/085473 A1 discloses a manufacturing method for an electroluminescent (EL) element, which can facilitate patterning for a luminescent layer containing quantum dots. The method includes: a wettability-changing-layer-forming step for forming a wettability changing layer containing a photocatalyst, on a substrate having a first electrode layer formed thereon, wherein wettability of the wettability-changing layer is changed by an effect of the photocatalyst associated with irradiation with energy; and a wettability-changing-pattern forming step for forming a wettability changing pattern composed of lyophilic regions and liquid-repellent regions, on a surface of the wettability changing layer, by irradiating the wettability changing layer with energy in a patterning manner. Additionally, in this method, a luminescent layer is formed onto each lyophilic region, by coating a luminescentlayer-forming coating liquid containing the quantum dots, around each of which ligands are attached.

US 2012/113672 A1 describes light-emitting quantum dot films, quantum dot lighting devices, and quantum dot-based backlight units, related compositions, components, and methods, and discloses quantum dot encapsulation and matrix materials, quantum dot films with protective barriers.

WO 2005/055330 A1 discloses a matrix of EL organic material having quantum dots embedded therein. Electrodes provide electrons and holes to the matrix forming excitons to be transferred to the quantum dots. Transfer molecules on the quantum dots are facilitating the transfer of excitons from the EL organic material to the quantum dots, by first transferring them to the transfer molecules. The transfer molecules are chosen to make a transfer rate of excitons from the organic material to the transfer molecules larger than a decay rate of excitons in the organic material. More specifically, the organic matrix forms a light emitting layer in a light emitting device. The EL organic material is an EL polymer.

US 2013/009131 A1 discloses a device including an emissive material comprising quantum dots. The device includes a first electrode and a second electrode, a layer comprising quantum dots disposed between the first electrode and the second electrodes, and a first interfacial layer disposed at the interface between a surface of the layer comprising quantum dots and a first layer in the device. A second interfacial layer is further disposed on the surface of the layer comprising quantum dots opposite to the first interfacial layer.

### SUMMARY

It is an object of the present invention to provide a method of preparing a quantum dot light-emitting diode (QD-LED) substrate. Preferably, the QD-LED substrate can be prepared with high resolution by a convenient process, and is suitable for mass production. Preferably, the preparation method has an improved qualified product rate and is suitable for mass production.

The object is achieved by the features of the independent claim. Further embodiments are defined in the corresponding dependent claims.

### BRIEF DESCRIPTION OF THE DRAWINGS

In order to clearly illustrate the technical solutions of the embodiments of the present invention, the drawings of the embodiments are briefly described below. Apparently, the drawings described below relate to only some embodiments of the present invention and thus are not limitative to the present invention.
FIG. 1A is a planar schematic view of a quantum dot light-emitting diode substrate manufactured according to an embodiment of the present invention, and FIG. 1B is a cross-sectional schematic view of the quantum dot light-emitting diode substrate along line A-A.
FIG. 2-1 to FIG. 2-20 are flow charts for forming a bonding layer and a quantum dot layer by heating and/or pressing.
FIG. 3-1 to FIG. 3-20 are flow charts for forming a bonding layer and a quantum dot layer by light adjustment.

### Reference signs:

101-substrate; 102-electrode; 103-bonding layer material; 104-mask plate; 105-ultraviolet light; 106-bonding layer; 107-green quantum dot; 108-green quantum dot layer; 109-blue quantum dot; 110-blue quantum dot layer; 111-red quantum dot; 112-red quantum dot layer; 113-quantum dot; 114-light-emitting layer; 115-subpixel light-emitting region; 116-pressurizer; 117-green light-emitting layer; 118-blue light-emitting layer; and 119-red light-emitting layer.

### DETAILED DESCRIPTION

To make clearer the objects, technical solutions and advantages of the embodiments of the present invention, a clear and full description of the technical solutions of some embodiments of the present invention will be made with reference to the accompanying drawings. Apparently, the described embodiments are just part rather than all of the embodiments of the present invention. Based on these embodiments of the present invention described, all the other embodiments obtained by a person of ordinary skill in the art, without any creative labor, fall within the protection scope of the present invention.

At least one embodiment, not according to the present invention, provides a quantum dot light-emitting diode substrate, a display panel comprising the quantum dot light-emitting diode substrate, and the present invention provides a method of preparing the quantum dot light-emitting diode substrate.

The quantum dot light-emitting diode substrate comprises a plurality of sub-pixel light-emitting regions, wherein each of the sub-pixel light-emitting regions comprises a light-emitting layer comprising a bonding layer and a quantum dot, the quantum dot being fixed in a corresponding sub-pixel light-emitting region by bonding to the bonding layer.

The quantum dot light-emitting diode substrate can be prepared with high resolution by a convenient process, and is suitable for mass production. The preparation method has an improved qualified product rate and is suitable for mass production. It shall be understood that the term "quantum dot light-emitting diode substrate" in the present application refers to a substrate comprising a light-emitting diode, wherein the light-emitting diode comprises a quantum dot configured to be capable of emitting light. Therefore, the light-emitting diode substrate in the present application can be an array substrate or a display substrate.

The term "organic functional group(s) of the quantum dot" in the present application refers to organic functional group(s) or organic compound(s) present on the surface of the quantum dot and capable of undergoing a crosslinking reaction. Likewise, the term "organic functional group(s) of the bonding layer" refers to organic functional group(s) or organic compound(s) present on the surface of the bonding layer and capable of undergoing a crosslinking reaction.

The following description will be made with reference to several embodiments. It should be understood that these embodiments are merely illustrative of the present invention and shall not be construed as limiting the invention.

### Embodiment 1

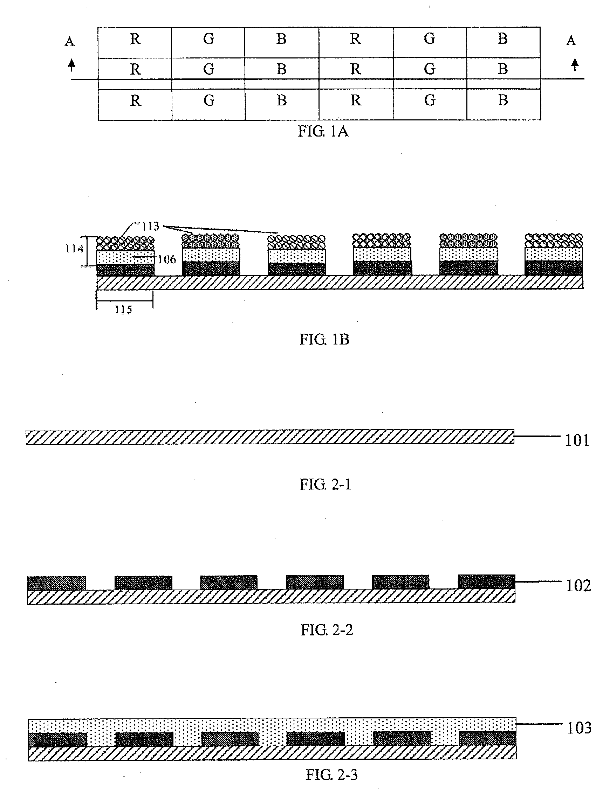

The present embodiment provides a quantum dot light-emitting diode (QD-LED) substrate obtained by the method according to the claimed invention. As shown in FIG. 1A and FIG. 1B, the quantum dot light-emitting diode (QD-LED) substrate comprises a plurality of sub-pixel light-emitting regions 115 (e.g., red, green, blue (RGB) sub-pixels arranged in an array), wherein each of the sub-pixel light-emitting regions 115 comprises a light-emitting layer 114 comprising a bonding layer 106 and a quantum dot 113 bonded to the bonding layer 106. The quantum dot 113 is not embedded in the bonding layer, for example, it is layered on the surface of the bonding layer. Each of the sub-pixel light-emitting regions 115 further comprises an electrode. Depending upon the desired color of the light to be emitted by each sub-pixel, the quantum dot 113 may comprise quantum dots of different colors, such as green light-emitting quantum dots, blue light-emitting quantum dots, and red light-emitting quantum dots.

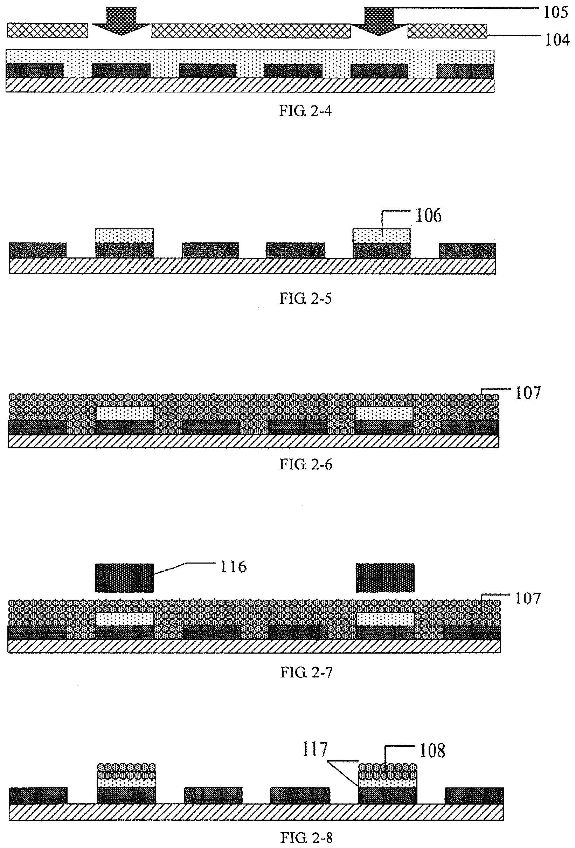

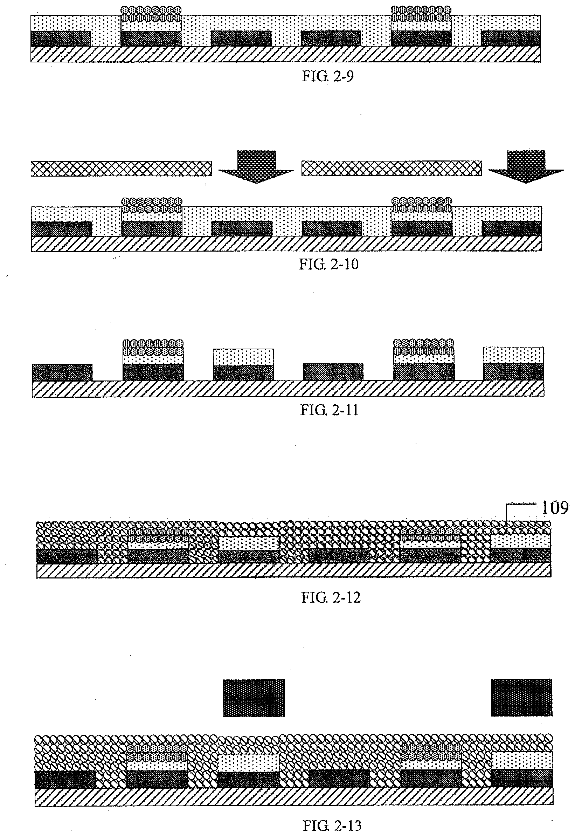

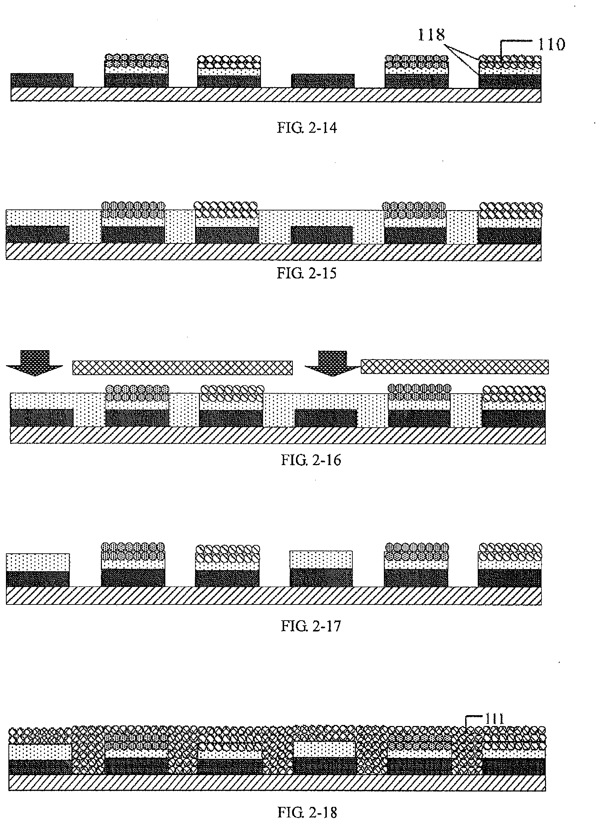

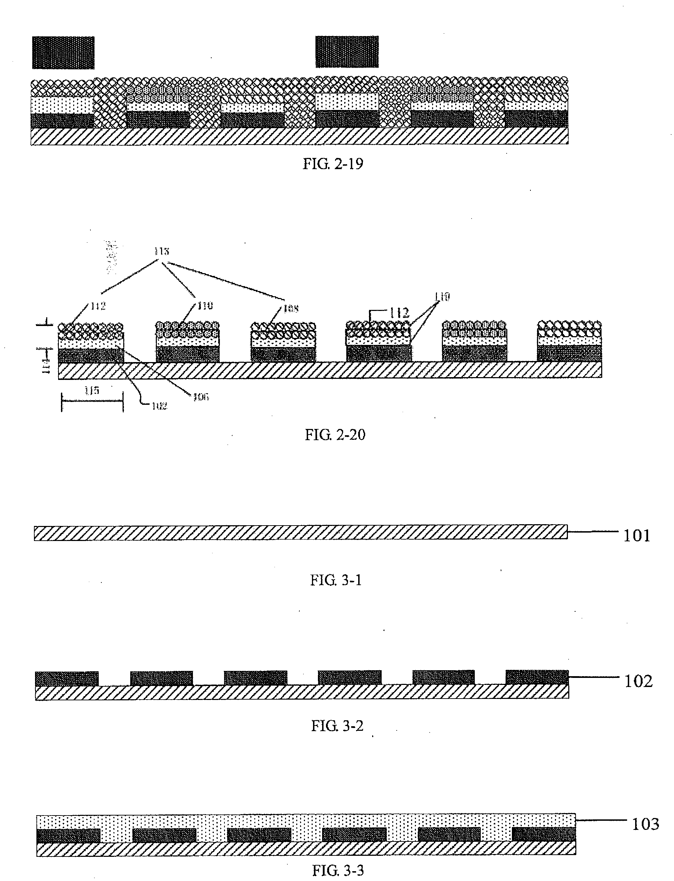

The present embodiment further provides a quantum dot light-emitting diode (QD-LED) substrate and a method of preparing the same. As shown in FIG. 2-20, the quantum dot light-emitting diode (QD-LED) substrate comprises a plurality of sub-pixel light-emitting regions 115, wherein each of the sub-pixel light-emitting regions 115 comprises a light-emitting layer 114 comprising a bonding layer 106 and a quantum dot 113 bonded to the bonding layer 106. The quantum dot 113 is at least partially embedded in the bonding layer 106. In the present application, the expression "the quantum dot is at least partially embedded in the bonding layer" means that each quantum dot is at least partially embedded in the bonding layer. Each of the sub-pixel light-emitting regions further comprises an electrode 102. Depending upon the desired color of the light to be emitted by each sub-pixel, the quantum dot may comprise quantum dots of different colors, such as green light-emitting quantum dots 107, blue light-emitting quantum dots 109, and red light-emitting quantum dots 111.

For example, the bonding layer 106 in the quantum dot light-emitting diode substrate comprises an organic resin. In general, the bonding layer may be formed of an organic resin. The organic resin may comprise an organic resin material with conductor properties or semiconductor properties. For example, the organic resin may be made conductive by adding thereto a conductive material such as carbon powder, or a conductive nano-metallic material such as a conductive nano-silver particle.

In some embodiments, the bonding layer 106 in the quantum dot light-emitting diode substrate is made of an organic semiconductor material or an organic conductor material. Organic semiconductors are organic materials having semiconductor properties (i.e., the electrical conductivity is between that of a metal and that of an insulator) and having a heat-activated conductivity between 10⁻¹⁰ and 100 S·cm⁻¹. Organic semiconductors can be classified as organic small molecules, polymers and donor-receptor complexes. Organic small molecules include aromatic hydrocarbons, dyes, and organometallic compounds, such as purpurine, phthalocyanine, malachite green, rhodamine B and the like. Polymers include polymers with a saturated main chain and conjugated polymers, such as polyphenyl, polyacetylene, polyvinyl carbazole, polyphenylene sulfide and the like. Donor-receptor complexes consist of electron donors and electron acceptors, and a complex of tetramethyl-p-phenylenediamine and tetracyanoquinodimethane is a typical example of donor-receptor complexes.

The conductivity type and conductivity of organic semiconductors can be modified by doping methods. For example, the organic semiconductor can be doped with a conductive material such as carbon powder, or a conductive nano-metallic material such as a conductive nano-silver particle so that the organic semiconductor material will have good conductivity to become an organic conductor material.

Organic conductor materials are organic compounds having conductivity, and include conductive polymer materials, and organic materials exhibiting conductor properties due to being doped with conductive materials.

For example, the organic resin in the quantum dot light-emitting diode substrate comprises an epoxy resin. Epoxy resins are a resin material which can be cured under conditions acceptable to a base substrate generally used without affecting the performance of other components on the base substrate, and can be modified in a variety of ways to adjust its conductivity.

The bonding layer 106 and the quantum dot 113 in the quantum dot light-emitting diode substrate are bonded by forming a crosslinked network, wherein the quantum dot 113 forms a quantum dot layer. That is, the quantum dot layer is fixed by a crosslinked network formed by a crosslinking reaction of organic functional groups between the bonding layer 106 and the quantum dot 113.

For example, the quantum dot 113 in the quantum dot light-emitting diode substrate is bonded to the bonding layer 106 by being embedded in the bonding layer 106. For another example, the quantum dot 113 may be bonded to the bonding layer 106 on the surface of the bonding layer 106. The specific bonding manner depends on the condition applied.

In some embodiments, the quantum dot 113 is embedded in the bonding layer 106 and also crosslinked with the bonding layer 106 to form a crosslinked network. The light-emitting layer thus formed has a better bonding strength between the quantum dot and the bonding layer, which can ensure a high qualified product rate.

For instance, the bonding layer 106 in the quantum dot light-emitting diode substrate has a thickness of about 5 to 50 nm, for example, 4.9 nm, and for another example, 51 nm. In some embodiments, the bonding layer 106 has a thickness which is 0.8 to 2.0 times the size of the quantum dot particles, e.g., 1.0 to 1.1 times the size of the quantum dot particles.

A method of preparing a quantum dot light-emitting diode substrate according to the claimed invention is provided by FIG. 2-1 to FIG. 2-20 which show a process for forming a bonding layer and a quantum dot layer by heating and/or pressing. The exemplary process is described below with reference to the accompanying drawings.

As shown in FIG. 2-1, a substrate 101 is provided, which is a base substrate. The base substrate is, for example, a glass substrate, a plastic substrate, or the like.

As shown in FIG. 2-2, an electrode material layer is formed on the substrate 101 and then patterned to obtain an electrode 102, which can be a cathode or an anode. Before the electrode 102 is formed, a switch element (e.g., a thin film transistor), a passivation layer or the like may be formed on the base substrate.

As shown in FIG. 2-3, a bonding layer material 103 is formed (for example, by coating or deposition) on the base substrate on which an electrode pattern has been formed. The bonding layer material 103 may be an organic semiconductor material or an organic conductor material.

As shown in FIG. 2-4 to Fig. 2-5: after forming the bonding layer material 103 on the substrate 101, the bonding layer material is patterned to form a bonding layer 106 corresponding to a pattern of a plurality of sub-pixel light-emitting regions. During the process of forming the bonding layer, the bonding layer 106 is formed in the exposed region for example, after covering the unexposed region with a mask plate 104, irradiating the exposed region with ultraviolet light, and being developed.

As shown in FIG. 2-6, when green quantum dots 107 are applied onto the bonding layer 106, the green quantum dots 107 are layered on the electrode 102 and the bonding layer 106 as well as the interval region therebetween.

As shown in FIG. 2-7 to FIG. 2-8, the green quantum dots 107 are bonded to the bonding layer 106 by external initiation conditions, such as heating, irradiation, or applying external pressure, or a combination thereof, so that the green quantum dots 107 are fixed in corresponding sub-pixel light-emitting regions. A pressurizer 116 is used in FIG. 2-7 to apply pressure to the quantum dots in the sub-pixel light-emitting regions. However, the methods of applying pressure are not limited to the above. For example, pressure may also be applied by using a whole plate. The pressure applied may be such that the quantum dots are at least partially embedded in the bonding layer. If a small pressure is to be applied, it can be done in an environment of elevated temperatures because the bonding layer becomes soft at elevated temperatures, making it easier for the quantum dots to be pressed into the bonding layer. After the quantum dots are pressed into the bonding layer, the unbonded green quantum dots 107 are removed to form a green light-emitting layer 117 comprising a bonding layer 106 and a green quantum dot layer 108 bonded to the bonding layer 106, as shown in FIG. 2-8. The quantum dots are partially or fully embedded in the bonding layer 106. For example, the heating method may be partial heating or overall uniform heating, and the external pressure may be applied either locally or as a whole.

FIG. 2-9 to FIG. 2-14 illustrate the process of forming a light-emitting layer comprising a bonding layer and a blue quantum dot layer 110 bonded to the bonding layer by a method of heating and applying external pressure. That is the process of repeating steps 2-3 to 2-8 except that blue quantum dots are used. For example, in the step as shown in FIG. 2-9, a new bonding layer can be formed, for example, by a method of screen printing so that the position where the green quantum dot layer 108 has been formed is not covered by the new bonding layer; alternatively, a new bonding material can be formed on the entire substrate, and then the bonding material at the position where the green quantum dot layer 108 is formed is removed by patterning so as to form the bonding layer. As shown in FIG. 2-14, a blue light-emitting layer 118 comprising a bonding layer and a blue quantum layer 110 bonded to the bonding layer is formed.

FIG. 2-15 to FIG. 2-20 illustrate the process of forming a red quantum dot layer 112 by applying red quantum dots 111 by means of heating and applying external pressure. That is the process of repeating steps 2-3 to 2-8 except that red quantum dots are used. For example, in the step as shown in FIG. 2-15, a new bonding layer may be formed, for example, by a screen printing method such that the position where the green quantum dot layer 108 or the blue quantum layer 110 has been formed is not covered by the new bonding layer; alternatively, a new bonding material may be formed on the entire substrate, and then the bonding material at the position where the green quantum dot layer 108 or the blue quantum layer 110 is formed is removed by patterning to form the bonding layer. As shown in FIG. 2-20, a red light-emitting layer 119 comprising a bonding layer and a red quantum dot layer 112 bonded to the bonding layer is formed.

In the embodiments of the present invention, there is no limitation on the order in which the green light-emitting layer 117, the blue light-emitting layer 118 and the red light-emitting layer 119 are formed, and they are also not limited to the formation of the red, green and blue light-emitting layers. Besides, in the actual preparation, for example, only one or two of the green light-emitting layer 117, the blue light-emitting layer 118 and the red light-emitting layer 119 may be formed by quantum dots, while an organic light-emitting layer can be used for the other light-emitting layer(s).

For example, the external initiation condition can be selected from the group consisting of external thermal initiation, external pressure initiation, and combinations thereof

The organic functional groups of the bonding layer 106 react with the organic functional groups of the quantum dot to form a crosslinked network taking a quantum dot inorganic core as the center.

For instance, the quantum dot is bonded to the bonding layer 106 by being embedded in the bonding layer 106. It can be partially or fully embedded in the bonding layer 106, depending upon the external force and the property (for example, thickness) of the bonding layer.

For example, the bonding layer 106 has a thickness of about 5 to 50 nm.

For example, the bonding layer 106 is made of an organic semiconductor material or an organic conductor material.

For example, the bonding layer 106 formed only corresponds to a pattern of sub-pixel light-emitting regions with one color, and the method comprises repeating steps 2-3 to 2-8 several times so as to form a pattern of sub-pixel light-emitting regions with several colors.

For example, the bonding layer 106 formed corresponds to a pattern of sub-pixel light-emitting regions with at least two colors, and the method comprises forming a layer of a bonding material on a substrate only once, patterning the layer of the bonding material so as to form a bonding layer corresponding to a pattern of a plurality of sub-pixel light-emitting regions, and repeating the following process at least twice to form a pattern of sub-pixel light-emitting regions with at least two colors: applying a quantum dot onto the bonding layer; allowing the quantum dot to be bonded to the bonding layer by an external initiation condition so as to fix the quantum dot in a corresponding sub-pixel light-emitting region; and removing unbonded quantum dots to form a light-emitting layer comprising the bonding layer and quantum dots bonded to the bonding layer.

In the case where a crosslinking reaction takes place to form a crosslinked network, the organic functional groups of the bonding layer react with the organic functional groups of the quantum dot to form a crosslinked network structure taking a quantum dot inorganic core as the center, thereby fixing the quantum dot in a corresponding sub-pixel region. For example, the organic functional groups of the quantum dot may be one or more selected from the group consisting of: an organic functional group capable of undergoing a crosslinking reaction under light, an organic functional group capable of undergoing a crosslinking reaction at an elevated temperature, and an organic functional group capable of undergoing a crosslinking reaction under pressure. The organic functional groups in the bonding layer are functional groups capable of undergoing a crosslinking reaction with the functional groups of the quantum dot. For example, in the case of photoinitiated bonding, the functional groups of the bonding layer material and the functional groups of the quantum dot are two different kinds of functional groups which are capable of reacting with each other under light (e.g., ultraviolet light, short wavelength visible light) to crosslink the quantum dots, thereby fixing the quantum dots. The functional groups can be selected from the group consisting of: alkenyl or dienyl such as 1,7-octadienyl, alkynyl or diynyl such as 1,9-octadiynyl, mercapto and the like. For example, in the case of thermally initiated bonding, the functional groups of the bonding layer material and the functional groups of the quantum dot are two different kinds of functional groups which are capable of reacting with each other at a certain temperature, for example, at a temperature of 60°C to 400°, such as 90°C, 130°C, or 230°C, to crosslink the quantum dots, thereby fixing the quantum dots. The functional groups can be selected from the group consisting of: amino, pyridine and the like. For example, in the case of pressure-initiated bonding, the functional groups of the bonding layer material and the functional groups of the quantum dot are two different kinds of functional groups which are capable of reacting with each other under pressure to crosslink the quantum dots, thereby fixing the quantum dots. For example, the bonding layer material may be an epoxy resin having a carboxylic group and comprise a material having functional groups which may undergo a crosslinking reaction, while the quantum dot may have a functional group such as thiol or phenol.

According to the claimed invention, the organic functional group(s) of the quantum dots are one or more selected from the group consisting of 1,7-octadiene, 1,9-octadiyne, mercapto, isoprene, amino, pyridine, carboxylic acid, thiol, phenol, or any combination thereof.

The quantum dot light-emitting diode (QD-LED) substrate according to embodiments of the present application can be prepared with high resolution by a convenient process, and is suitable for mass production. The method of preparing the QD-LED substrate has an improved qualified product rate and is suitable for mass production.

The present embodiment further illustrates a structure of a specific display panel and a method of preparing the same.

The display panel comprises: a substrate, a TFT array, a cathode, an electron common layer, a bonding layer, a RGB (red, green, blue) three-color quantum dot sub-pixel, a hole common layer, an anode, a packaging material and an upper polarizing plate. The method of preparing the display panel is as follows.

A transparent substrate was cleaned, and then the gate electrode metal Mo (with a thickness of 200 nm) was deposited and patterned; a gate electrode dielectric SiO₂ (with a thickness of 150 nm) was formed; an active layer IGZO (with a thickness of 40 nm) was formed and patterned; a source/drain electrode metal Mo (with a thickness of 200 nm) was formed and patterned; a passivation layer SiO₂ (with a thickness of 300 nm) was formed and patterned; a pixel electrode ITO (with a thickness of 40 nm) was formed and patterned; and finally an acrylic material was spin-coated and deposited, and then photolithographically etched and cured to form a pixel defining layer with a thickness of about 1.5 µm, thereby obtaining a TFT array portion. Afterwards, a flat layer could be formed on the TFT array.

The surface of the substrate on which the TFT array was to be formed could be plasma-treated before the quantum dot light-emitting diode (QD-LED) portion was prepared. A low work function metal was sputtered or vapor deposited as a cathode, followed by preparing an electron injection layer and an electron transport layer such as ZnO nanoparticles or LiF by spin-coating. A first layer of an epoxy resin bonding material was then applied, and the bonding material was retained in the green sub-pixel region by exposure, development and fixation to form a bonding layer used for green sub-pixels. Afterwards, a green quantum dot material was applied. The quantum dot material was synthesized by a traditional thermal injection method, where the ligands thereof include trioctylphosphine, trioctylphosphine oxide, oleylamine, oleic acid and the like. Afterwards, the epoxy resin was bonded to the quantum dot material at a temperature of 200°C and under a pressure of 0.5-5 Mpa, and was then developed and fixed to form a green sub-pixel. Likewise, a second layer of the epoxy resin bonding material was applied, and the bonding material was retained in the blue sub-pixel region by exposure, development and fixation to form a bonding layer used for blue sub-pixels, and then a blue quantum dot material (which was synthesized by a traditional thermal injection method, and the ligands of which include trioctylphosphine, trioctylphosphine oxide, oleylamine, oleic acid and the like) was applied. Afterwards, the epoxy resin was bonded to the quantum dot material at a temperature of 200°C and under a pressure of 0.5-5 Mpa, and was then developed and fixed to form a blue sub-pixel; finally, a third layer of the epoxy resin bonding material was applied, and the bonding material was retained in the red sub-pixel region by exposure, development and fixation to form a bonding layer used for red sub-pixels, and then a red quantum dot material was applied. Afterwards, the epoxy resin was bonded to the quantum dot material at a temperature of 200°C and under a pressure of 0.5-5 Mpa, and was then developed and fixed to form a red sub-pixel. Then a second common layer (a hole injection layer and a hole transport layer) was spin-coated or vapor deposited, for example, PEDOT (poly(3,4-ethylenedioxythiophene)) : PSS (poly(styrenesulfonate)) and TFB (poly[(9,9-dioctylfluorenyl-2,7-diyl)-co-(4,4'-(N-(4-sec-butylphenyl)diphenylamine)]) were respectively spin-coated, wherein the hole injection layer and the hole transport layer have an entire thickness of about 50 to 100 nm; and finally, an anode metal thin layer was vapor deposited and sputtered, for example, by using an Au:ITO layer or the like, having a thickness of about 500-1000 nm. After vapor deposition, packaging and cutting were performed to obtain the panel portion of the Active Matrix - Quantum Dots - Light Emitting Diode (AM-QD-LED).

In the present embodiment, the manner of achieving elevated temperatures and pressures (e.g., a temperature of 200°C and a pressure of 0.5-5 Mpa) is not particularly limited, and a manner generally known to a person of ordinary skill in the art may be used. In some embodiments, the heating temperature is achieved by heating a sample bearing bench (i.e., a bench with heating function), or by means of infrared radiation heating or the like. In some embodiments, the method of applying pressure comprises applying pressure by rolling the roller and applying pressure using a flat plate or a patterned plate.

The AM-QD-LED panel emits light in a top-emitting manner, and the minimum size of the sub-pixel that can be produced is about 10 to 30 nm, which is about 300 to 800 ppi.

### Embodiment 2

### In the present embodiment, a bonding layer and a quantum dot layer are formed by light irradiation, and crosslink between the bonding layer and the quantum dot layer occurs to form a crosslinked network taking a quantum dot inorganic core as the center.

The present embodiment provides a quantum dot light-emitting diode (QD-LED) substrate, obtained by the method of the claimed invention, as shown in FIG. 1, comprising a plurality of sub-pixel light-emitting regions 115, wherein each of the sub-pixel light-emitting regions comprises a light-emitting layer 114 comprising a bonding layer 106 and a quantum dot 113 bonded to the bonding layer 106. In some embodiments, the quantum dot 113 is not embedded in the bonding layer and only exists on the surface of the bonding layer. In some embodiments, the quantum dot 113 is partially embedded in the bonding layer. Each of the sub-pixel light emitting regions 115 further comprises an electrode, and the quantum dot 113 comprises quantum dots of different colors, such as a green light-emitting quantum dot, a blue light-emitting quantum dot, a red light-emitting quantum dot, and the like.

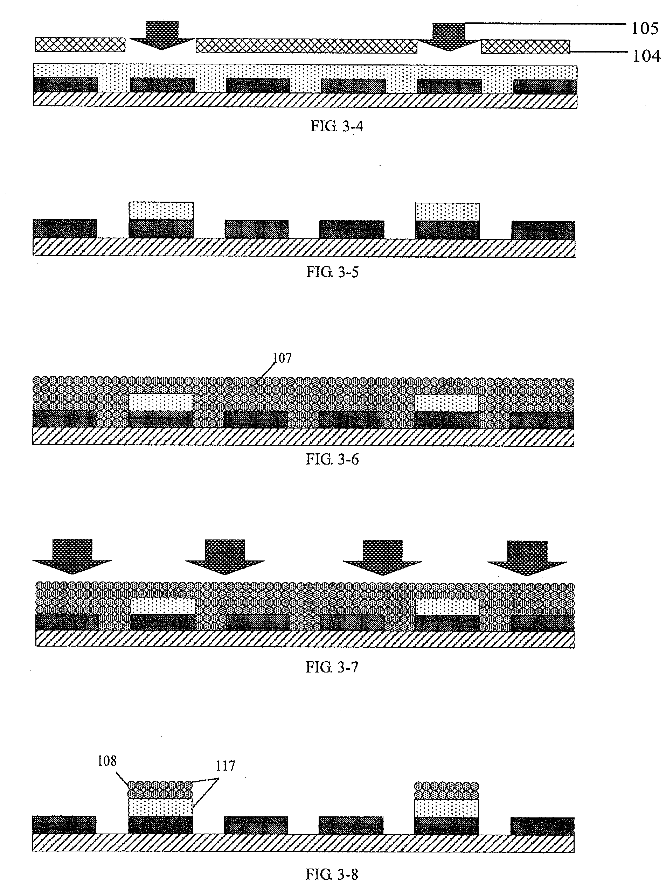

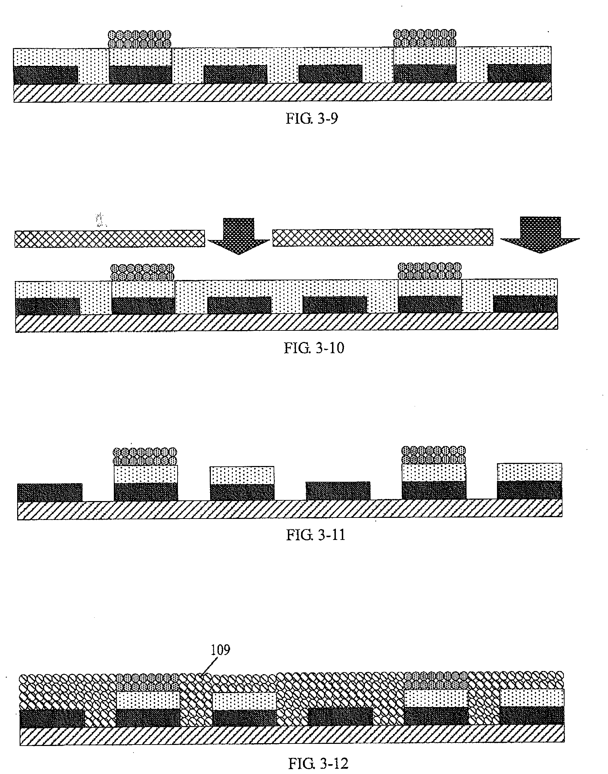

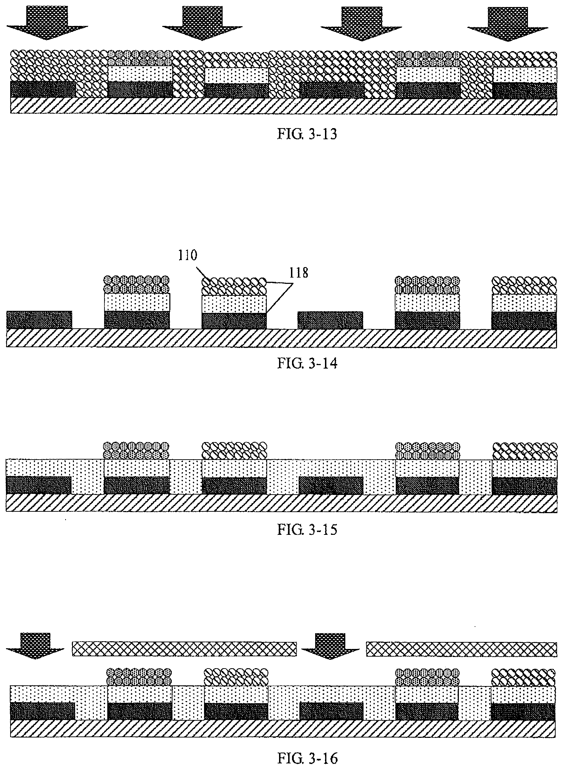

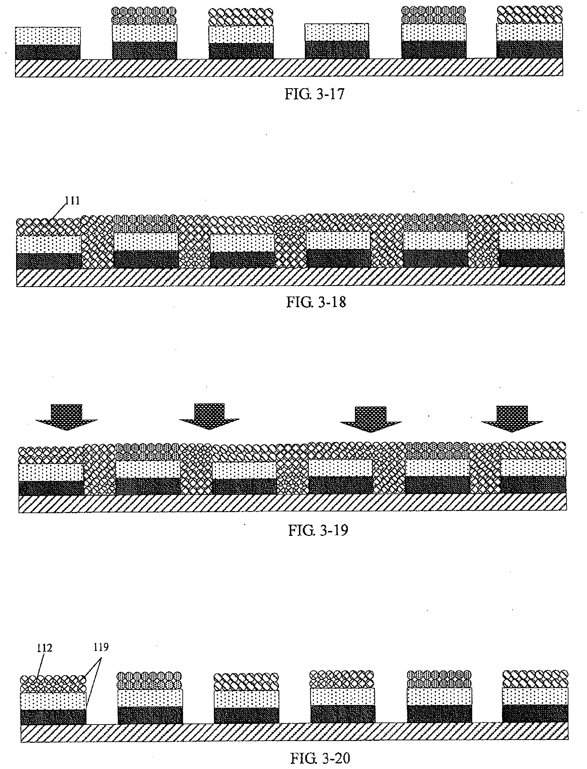

FIG. 3-1 to FIG. 3-20 illustrate the process of preparing a QD-LED substrate which comprises bonding quantum dots to a bonding layer by ultraviolet light initiation. In the present embodiment, the light-emitting layer comprises a bonding layer and a quantum dot layer bonded to the bonding layer. Crosslink between the quantum dot layer and the bonding layer occurs on the bonding surface so as to form a crosslinked network. The quantum dots used in the present embodiment are photosensitive crosslinkable quantum dots having functional groups such as alkenyl, alkynyl or thiol capable of undergoing a crosslinking reaction. According to the invention, the organic functional group(s)of the quantum dots capable of reacting under light are one or more selected from the group consisting of 1,7-octadiene, 1,9-octadiyne, mercapto, isoprene or thiol.

The bonding layer has functional groups, for example, alkenyl, dienyl, alkynyl, diynyl and the like, capable of undergoing a crosslinking reaction with the photosensitive crosslinkable quantum dots.

The teachings of Embodiment 1 are also applicable to Embodiment 2, unless contrary to the explicit teachings of Embodiment 2.

A method of preparing the quantum dot light-emitting diode substrate is provided, as shown in FIG. 3-1 to FIG. 3-20. It comprises subjecting the bonding layer and the quantum dot layer to a crosslinking reaction by ultraviolet light to form a crosslinked network taking a quantum dot inorganic core as the center, thereby forming a light-emitting layer. The exemplary process is described below with reference to the accompanying drawings.

As shown in FIG. 3-1, a substrate 101 is provided, which is a base substrate.

As shown in FIG. 3-2, an electrode material layer is formed on the substrate 101 and then patterned to obtain an electrode 102, which can be a cathode or an anode. Before the electrode 102 is formed, a switch element (e.g., a thin film transistor) may be formed on the base substrate.

As shown in FIG. 3-3, a bonding layer material 103 is formed (for example, by coating or deposition) on the base substrate on which an electrode pattern has been formed. The bonding layer material 103 may be an organic semiconductor material or an organic conductor material.

As shown in FIG. 3-4 to Fig. 3-5: after forming the bonding layer material 103 on the substrate 101, the bonding layer material is patterned to form a bonding layer 106 corresponding to a pattern of a plurality of sub-pixel light-emitting regions. During the process of forming the bonding layer, the bonding layer 106 is formed in the exposed region for example, after covering the unexposed region with a mask plate 104, irradiating the exposed region with ultraviolet light, and being developed.

As shown in FIG. 3-6, when green quantum dots 107 are applied on the bonding layer 106, the green quantum dots 107 are layered on the electrode 102 and the bonding layer 106 as well as the interval region therebetween.

As shown in FIG. 3-7 to FIG. 3-8, the green quantum dots 107 and the bonding layer 106 are crosslinked by ultraviolet irradiation to form a crosslinked network taking a quantum dot inorganic core as the center, thereby fixing the green quantum dots 107 in a corresponding sub-pixel light-emitting region. After forming the crosslinked network, the unbonded green quantum dots 107 are removed to form a green light-emitting layer 117 comprising a bonding layer 106 and a green quantum dot layer 108 bonded to the bonding layer 106, as shown in FIG. 3-8. The quantum dots form a quantum dot layer on the surface of the bonding layer.

FIG. 3-9 to FIG. 3-14 illustrate the process of forming a light-emitting layer comprising a bonding layer and a blue quantum dot layer 110 by a method of ultraviolet crosslinking. That is the process of repeating steps 3-3 to 3-8 except that blue crosslinkable quantum dots are used. As shown in FIG. 3-14, a blue light-emitting layer 118 comprising a bonding layer and a blue quantum dot layer 110 bonded to the bonding layer is formed.

FIG. 3-15 to FIG. 3-20 illustrate the process of forming a light-emitting layer comprising a bonding layer and a red quantum dot layer 112 by a method of ultraviolet crosslinking. That is the process of repeating steps 3-3 to 3-8 except that red crosslinkable quantum dots are used. As shown in FIG. 3-20, a red light-emitting layer 119 comprising a bonding layer and a red quantum dot layer 112 bonded to the bonding layer is formed.

In the present embodiment, there is no limitation on the order in which the green light-emitting layer 117, the blue light-emitting layer 118 and the red light-emitting layer 119 are formed. Besides, in the actual preparation, for example, only one or two of the green light-emitting layer 117, the blue light-emitting layer 118 and the red light-emitting layer 119 may be formed by quantum dots, while an organic light-emitting layer can be used for the other light-emitting layer(s).

For example, the bonding layer 106 has a thickness of about 5 to 50 nm.

For example, the bonding layer 106 is made of an organic semiconductor material or an organic conductor material.

For example, the bonding layer 106 formed only corresponds to a pattern of sub-pixel light-emitting regions with one color, and the method comprises repeating steps 3-3 to 3-8 several times so as to form a pattern of sub-pixel light-emitting regions with several colors.

For example, the bonding layer 106 formed corresponds to a pattern of sub-pixel light-emitting regions with at least two colors, and the method comprises forming a layer of a bonding material on the substrate only once, patterning the layer of the bonding material so as to form a bonding layer corresponding to a pattern of a plurality of sub-pixel light-emitting regions, and repeating the following process at least twice to form a pattern of sub-pixel light-emitting regions with at least two colors: applying a quantum dot onto the bonding layer; allowing the quantum dot to be bonded to the bonding layer by an external initiation condition so as to fix the quantum dot in a corresponding sub-pixel light-emitting region; and removing unbonded quantum dots to form a light-emitting layer comprising the bonding layer and quantum dots bonded to the bonding layer. In a particular embodiment, the external initiation condition is ultraviolet irradiation.

In the case where a crosslinking reaction takes place to form a crosslinked network, the organic functional groups of the bonding layer react with the organic functional groups of the quantum dot to form a crosslinked network structure taking a quantum dot inorganic core as the center, thereby fixing the quantum dot in a corresponding sub-pixel region. For example, the organic functional groups of the quantum dot may be one or more organic functional group(s) capable of undergoing a crosslinking reaction under light. Moreover, the organic functional groups in the bonding layer are functional groups capable of undergoing a crosslinking reaction with the functional groups of the quantum dot. For example, in the case of photoinitiated bonding, the functional groups of the bonding layer material and the functional groups of the quantum dot are two different kinds of functional groups which are capable of reacting with each other under light (e.g., ultraviolet light, short wavelength visible light) to crosslink quantum dots, thereby fixing the quantum dots. The functional groups can be selected from the group consisting of: dienyl such as 1,7-octadienyl, diynyl such as 1,9-octanediol, mercapto, isoprene and the like. The functional groups of the bonding layer material/the functional groups of the quantum dot may be configured, for example, as mercapto/alkenyl, mercapto/dienyl, mercapto/alkynyl, mercapto/diynyl, alkenyl/alkenyl, alkenyl/dienyl, and dienyl /dienyl.

According to the claimed invention, the organic functional group(s) of the quantum dots capable of reacting under light are one or more selected from the group consisting of 1,7-octadiene, 1,9-octadiyne, mercapto, isoprene or thiol.

The quantum dot light-emitting diode (QD-LED) substrate according to embodiments of the present application can be prepared with high resolution by a convenient process, and is suitable for mass production. The method of preparing the QD-LED substrate has an improved qualified product rate and is suitable for mass production.

The present embodiment further illustrates a structure of a specific display panel and a method of preparing the same.

The display panel comprises: a substrate, a TFT array, a cathode, an electron common layer, a bonding layer, a red, green and blue three-color quantum dot sub-pixel, a hole common layer, an anode, a packaging material and an upper polarizing plate. The method of preparing the display panel is as follows.

A transparent substrate was cleaned by a standard method, and then the gate electrode metal Mo (with a thickness of 200 nm) was deposited and patterned; a gate electrode dielectric SiO₂ (with a thickness of 150 nm) was formed; an active layer IGZO (with a thickness of 40 nm) was formed and patterned; a source/drain electrode metal Mo (with a thickness of 200 nm) was formed and patterned; a passivation layer SiO₂ (with a thickness of 300 nm) is formed and patterned; a pixel electrode ITO (with a thickness of 40 nm) was formed and patterned; and finally an acrylic material was spin-coated and deposited, and then photolithographically etched and cured to form a pixel defining layer with a thickness of about 1.5 µm, thereby obtaining a TFT backplate portion.

Photosensitive crosslinkable quantum dots were prepared as follows. The quantum dot material was synthesized by a traditional thermal injection method, where the ligands thereof include trioctylphosphine, trioctylphosphine oxide, oleylamine, oleic acid, and the like. Under ambient conditions, the green quantum dot material, the blue quantum dot material and the red quantum dot material were respectively contacted with a pyridine solvent at a weight ratio of 1:5 under stirring for 2 hours, so as to replace the ligands of the quantum dot material with pyridine. Then the quantum dots with a pyridine ligand were separated by centrifugation or the like. Afterwards, the quantum dots with a pyridine ligand were reacted with a crosslinkable ligand material (thioglycolic acid) having a monofunctional group to replace the pyridine ligand with a ligand having a monofunctional group, thereby obtaining monofunctional crosslinkable quantum dots (including: green photosensitive quantum dots, blue photosensitive quantum dots and red photosensitive quantum dots). The monofunctional crosslinkable quantum dots can react with a ligand having a plurality of alkenyl functional groups to form a crosslinked network.

The backplate surface of TFT was plasma-treated before the QD-LED portion was prepared. A low work function metal was sputtered or vapor deposited as a cathode, followed by preparing an inorganic electron injection layer and an electron transport layer such as ZnO nanoparticles or LiF by spin-coating. A first layer of a negative photosensitive bonding material was then applied, and the bonding material was retained in the green sub-pixel region by exposure, development and fixation to form a bonding layer (the surface of the bonding layer has alkenyl functional groups) used for green sub-pixels. Afterwards, the green photosensitive quantum dot was applied. Overall exposure was performed using ultraviolet light such that the green photosensitive quantum dot and the alkenyl functional groups in the bonding layer undergo a click reaction, and then development and fixation were performed to form a green sub-pixel. Likewise, a second layer of the negative photosensitive bonding material was applied, and the bonding material was retained in the blue sub-pixel region by exposure, development and fixation to form a bonding layer (the surface of the bonding layer has alkenyl functional groups) used for blue sub-pixels. Afterwards, the blue photosensitive quantum dot was applied. Overall exposure was performed using ultraviolet light, and then development and fixation were performed to form a blue sub-pixel. Finally, a third layer of the negative photosensitive bonding material was applied, and the bonding material was retained in the red sub-pixel region by exposure, development and fixation to form a bonding layer (the surface of the bonding layer has alkenyl functional groups) used for red sub-pixels. Afterwards, the red photosensitive quantum dot was applied. Overall exposure was performed using ultraviolet light, and then development and fixation were performed to form a red sub-pixel. At last, a second common layer (a hole injection layer and a hole transport layer) was spin-coated or vapor deposited, for example, PEDOT:PSS and TFB were respectively spin-coated, wherein the hole injection layer and the hole transport layer have an entire thickness of about 50 to 100 nm; then, an anode metal thin layer was vapor deposited and sputtered, for example, by using an Au:ITO layer or the like, having a thickness of about 500-1000 nm. After vapor deposition, packaging and cutting were performed to obtain the entire display panel of the AM-QD-LED.

It shall be noted that the bonding materials for forming the bonding layer in the embodiments are not particularly limited as long as the object of the embodiments of the present invention can be achieved. The functional groups (e.g., alkenyl, alkynyl and the like) capable of undergoing a crosslinking reaction in the bonding layer can be formed by including a material having functional groups capable of undergoing a crosslinking reaction, such as a polybutadiene or styrene-maleic anhydride copolymer, in a bonding material, or by applying these materials on the surface of the bonding layer so that the surface of the bonding layer has functional groups capable of undergoing a crosslinking reaction. In some embodiments, the bonding layer is formed of a polybutadiene or styrene-maleic anhydride copolymer.

The AM-QD-LED panel emits light in a top-emitting manner, and the minimum size of the sub-pixel that can be produced is about 10 to 30 nm, which is about 300 to 800 ppi.

## Claims

1. A method of preparing a quantum dot light-emitting diode substrate, comprising:
Step 1 : forming a layer (103) of a bonding material on a substrate (101) and patterning the layer of the bonding material to form a bonding layer (106) corresponding to a pattern of a plurality of sub-pixel light-emitting regions;
Step 2: applying a continuous quantum dot layer (107) comprising quantum dots onto the bonding layer;
Step 3: allowing the quantum dots to be bonded to the bonding layer by an external initiation condition (116) so as to fix the quantum dots in a corresponding sub-pixe! light-emitting region: and
Step 4: removing unbonded quantum dots to form a light-emitting layer (117) comprising the bonding layer and quantum dots (108) bonded to the bonding layer;
wherein organic functional group(s) of the bonding layer are reacting with organic functional group(s) of the quantum dots to form a crosslinked network taking a quantum dot inorganic core as the center, thereby fixing the quantum dots in a corresponding sub-pixel light-emitting region;
wherein the organic functional group(s) of the quantum dots are one or more selected from the group consisting of 1,7-octadiene, 1,9-octadiyne, mercapto, isoprene, amino, pyridine, carboxylic acid, thiol, phenol, or any combination thereof.

2. The method of claim 1, wherein the external initiation condition is selected from the group consisting of external photoinitiation, external thermal initiation, external pressure initiation, and combinations thereof.

3. The method of claim 1 or 2, wherein the bonding material comprises an organic resin, preferably an epoxy resin.

4. The method of claim 1 or 2, wherein the quantum dots are bonded to the bonding layer by being embedded in the bonding layer, and the bonding layer has a thickness of about 5 to 50 nanometers.

5. The method of claim 1 or 2, wherein the bonding material comprises an organic semiconductor material, an organic conductor material, or a combination thereof.

6. The method of claim 1 or 2. wherein
the bonding layer formed in Step 1 only corresponds to a pattern of sub-pixel light-emitting regions with one color, and
the method comprises: repeating steps 1-4 several times so as to form a pattern of subpixel light-emitting regions with several colors.

7. The method of claim 1 or 2. wherein the method comprises:
performing Step 1 only once to form the bonding layer corresponding to a pattern of sub-pixel light-emitting regions with at least two colors, and
repeating steps 2-4 at least twice, thereby forming a pattern of sub-pixel light-emitting regions with at least two colors.

8. The method of claim 1, wherein the organic functional group(s) of the quantum dots are capable of undergoing a crosslinking reaction under light, a crosslinking reaction at an elevated temperature, or a crosslinking reaction under pressure.

## Patentansprüche

1. Verfahren zur Herstellung eines lichtemittierenden Dioden-Substrats mit Quanten-Punkten, aufweisend:
Schritt 1: Bilden einer Schicht (103) aus einem Bindematerial auf einem Substrat (101) und Strukturieren der Schicht aus dem Bindematerial, um eine Bindeschicht (106) zu bilden, die einer Struktur aus einer Vielzahl von lichtemittierenden Sub-Pixel-Bereichen entspricht;
Schritt 2: Aufbringen einer kontinuierlichen Quanten-Punkt-Schicht (107), die Quanten-Punkte enthält, auf die Bindungsschicht;
Schritt 3: Binden-lassen der Quanten-Punkte durch eine externe Aktivierungsbedingung (116) an die Bindungsschicht, um die Quanten-Punkte in einem entsprechenden lichtemittierenden Sub-Pixel-Bereich zu fixieren; und
Schritt 4: Entfernen von ungebundenen Quanten-Punkten, um eine lichtemittierende Schicht (117) zu bilden, die die Bindungsschicht und an die Bindungsschicht gebundene Quanten-Punkte (108) aufweist;
wobei die organische(n) funktionelle(n) Gruppe(n) der Bindungsschicht mit der (den) organischen funktionellen Gruppe(n) der Quanten-Punkte reagiert (reagieren), um ein vernetztes Netzwerk zu bilden, das einen anorganischen Quanten-Punkt-Kern als Zentrum nimmt, wodurch die Quanten-Punkte in einem entsprechenden lichtemittierenden Sub-Pixel-Bereich fixiert werden;
wobei die organische(n) funktionelle(n) Gruppe(n) der Quanten-Punkte eine oder mehrere ist/sind, die aus der Gruppe ausgewählt ist/sind, die aus 1,7-Octadien, 1,9-Octadin, Mercapto, Isopren, Amino, Pyridin, Carbonsäure, Thiol, Phenol oder einer Kombination davon besteht.

2. Verfahren nach Anspruch 1, wobei die externe Aktivierungsbedingung ausgewählt ist aus der Gruppe bestehend aus externer Photo-Aktivierung, externer thermischer Aktivierung, externer Druck-Aktivierung und Kombinationen davon.

3. Verfahren nach Anspruch 1 oder 2, wobei das Bindematerial ein organisches Harz, vorzugsweise ein Epoxidharz, aufweist.

4. Verfahren nach Anspruch 1 oder 2, wobei die Quanten-Punkte an die Bindungsschicht gebunden werden, indem sie in die Bindungsschicht eingebettet werden, und die Bindungsschicht eine Dicke von etwa 5 bis 50 Nanometern aufweist.

5. Verfahren nach Anspruch 1 oder 2, wobei das Bindematerial ein organisches Halbleitermaterial, ein organisches Leitermaterial oder eine Kombination davon aufweist.

6. Verfahren nach Anspruch 1 oder 2, wobei
die in Schritt 1 gebildete Verbindungsschicht nur eine Struktur von lichtemittierenden Sub-Pixel-Bereichen mit einer Farbe entspricht, und
das Verfahren aufweist: mehrmaliges Wiederholen der Schritte 1-4, um eine Struktur von lichtemittierenden Sub-Pixel-Bereichen mit mehreren Farben zu bilden.

7. Verfahren nach Anspruch 1 oder 2, wobei das Verfahren aufweist:
einmaliges Durchführen von Schritt 1, um die Verbindungsschicht zu bilden, die einer Struktur von lichtemittierenden Sub-Pixel-Bereichen mit mindestens zwei Farben entspricht, und
mindestens zweimaliges Wiederholen der Schritte 2 bis 4, wodurch eine Struktur von lichtemittierenden Sub-Pixel-Bereichen mit mindestens zwei Farben gebildet wird.

8. Verfahren nach Anspruch 1, wobei die organische(n) funktionelle(n) Gruppe(n) der Quanten-Punkte eine Vernetzungsreaktion unter Licht, eine Vernetzungsreaktion bei erhöhter Temperatur oder eine Vernetzungsreaktion unter Druck eingehen können.

## Revendications

1. Procédé de préparation d'un substrat de diodes électroluminescentes à points quantiques, comprenant :
Étape 1 : la formation d'une couche (103) d'un matériau de liaison sur un substrat (101) et la structuration en termes de motif de la couche du matériau de liaison pour former une couche de liaison (106) qui correspond à un motif d'une pluralité de régions électroluminescentes de sous-pixel ;
Étape 2 : l'application d'une couche continue de points quantiques (107) qui comprend des points quantiques sur la couche de liaison ;
Étape 3 : le fait de faire en sorte que les points quantiques soient liés à la couche de liaison au moyen d'une condition d'initiation externe (116) de manière à fixer les points quantiques dans une région électroluminescente de sous-pixel correspondante ; et
Étape 4 : l'enlèvement de points quantiques non liés pour former une couche électroluminescente (117) qui comprend la couche de liaison et des points quantiques (108) qui sont liés à la couche de liaison ;
dans lequel un/des groupe(s) fonctionnel(s) organique(s) de la couche de liaison réagit/réagissent avec un/des groupe(s) fonctionnel(s) organique(s) des points quantiques pour former un réseau réticulé en prenant en tant que centre un noyau inorganique de point(s) quantique(s), d'où ainsi la fixation des points quantiques dans une région électroluminescente de sous-pixel correspondante ; et
dans lequel le/les groupe(s) fonctionnel(s) organique(s) des points quantiques est/sont un ou plusieurs sélectionné(s) parmi le groupe qui est constitué par 1,7-octadiène, 1,9-octadiyne, mercapto, isoprène, amino, pyridine, acide carboxylique, thiol, phénol, ou une quelconque combinaison afférente.

2. Procédé selon la revendication 1, dans lequel la condition d'initiation externe est sélectionnée parmi le groupe qui est constitué par une photoinitiation externe, une initiation thermique externe, une initiation par pression externe, et des combinaisons afférentes.

3. Procédé selon la revendication 1 ou 2, dans lequel le matériau de liaison comprend une résine organique, de préférence une résine époxy.

4. Procédé selon la revendication 1 ou 2, dans lequel les points quantiques sont liés à la couche de liaison en étant intégrés dans la couche de liaison, et la couche de liaison présente une épaisseur d'environ 5 à 50 nanomètres.

5. Procédé selon la revendication 1 ou 2, dans lequel le matériau de liaison comprend un matériau semiconducteur organique, un matériau conducteur organique, ou une combinaison afférente.

6. Procédé selon la revendication 1 ou 2, dans lequel :
la couche de liaison qui est formée au niveau de l'Étape 1 correspond seulement à un motif de régions électroluminescentes de sous-pixel selon une seule couleur ; et
le procédé comprend : la répétition des Étapes 1 à 4 plusieurs fois de manière à former un motif de régions électroluminescentes de sous-pixel selon plusieurs couleurs.

7. Procédé selon la revendication 1 ou 2, dans lequel le procédé comprend :
la réalisation de l'Étape 1 seulement une fois pour former la couche de liaison qui correspond à un motif de régions électroluminescentes de sous-pixel selon au moins deux couleurs ; et
la répétition des Étapes 2 à 4 au moins deux fois, d'où ainsi la formation d'un motif de régions électroluminescentes de sous-pixel selon au moins deux couleurs.

8. Procédé selon la revendication 1, dans lequel le/les groupe(s) fonctionnel(s) organique(s) des points quantiques peuvent subir une réaction de réticulation sous l'effet de la lumière, une réaction de réticulation à une température élevée ou une réaction de réticulation sous pression.
